# EUROPÄISCHE PATENTSCHRIFT

(11) **EP 1 497 869 B1**
(45) Veröffentlichungstag und Bekanntmachung des Hinweises auf die Patenterteilung: **14.03.2012**
(21) Anmeldenummer: 03724870.5
(22) Anmeldetag: 17.04.2003
(51) Int. Cl.: H01L 29/92, H01L 27/06

(54) **HALBLEITERBAUELEMENT MIT INTEGRIERTER, EINE MEHRZAHL AN METALLISIERUNGSEBENEN AUFWEISENDER KAPAZITÄTSSTRUKTUR**
SEMICONDUCTOR COMPONENT COMPRISING AN INTEGRATED CAPACITOR STRUCTURE THAT HAS A PLURALITY OF METALLIZATION PLANES
COMPOSANT A SEMI-CONDUCTEUR DANS LEQUEL EST INTEGREE UNE STRUCTURE DE CONDENSATEUR COMPRENANT UNE PLURALITE DE COUCHES DE METALLISATION

(30) Priorität: 19.04.2002 DE 10217566
(43) Veröffentlichungstag der Anmeldung: 19.01.2005
(73) Patentinhaber: Infineon Technologies AG, 85579 Neubiberg (DE)
(72) Erfinder: ABDALLAH, Hichem, 40211 Düsseldorf (DE); ÖHM, Jürgen, 40885 Ratingen (DE)
(74) Vertreter: Graf Lambsdorff, Matthias
(86) Internationale Anmeldenummer: PCT/DE2003/001304
(87) Internationale Veröffentlichungsnummer: WO 2003/090283

(56) Entgegenhaltungen:
- EP-B1- 1 497 862
- WO-A-01/91144
- WO-A-01/99163
- DE-A- 10 019 839
- US-A- 5 583 359
- US-A- 6 100 591
- US-B1- 6 297 524
- APARICIO R ET AL: "Capacity limits and matching properties of integrated capacitors" IEEE JOURNAL OF SOLID-STATE CIRCUITS, IEEE INC. NEW YORK, US, Bd. 37, Nr. 3, März 2002 (2002-03), Seiten 384-393, XP002252607 ISSN: 0018-9200

## Beschreibung

Die vorliegende Erfindung betrifft ein Halbleiterbauelement mit einem Halbleitersubstrat auf dem eine Isolationsschicht ausgebildet ist, wobei in der Isolationsschicht eine monolithisch integrierte Kapazitätsstruktur ausgebildet ist.

In den meisten analogen Schaltungsteilen gemischt digitalanaloger Schaltungen werden Kondensatoren mit hohem Kapazitätswert, großer Linearität und hoher Güte benötigt. Um die Kosten der Herstellung des Bauelements möglichst gering zu halten, ist es erforderlich, dass die Herstellung der Kapazitätsstrukturen möglichst wenig Prozessschritte erfordern. Des Weiteren ist mit der fortschreitenden Miniaturisierung der Bauelemente und integrierten Schaltungen auch die Forderung nach möglichst wenig Flächenbedarf für die Kapazitätsstruktur einhergehend.

Aus der Patentschrift US 5,583,359 ist eine Kapazitätsstruktur für einen integrierten Schaltkreis bekannt. Dort wird eine Mehrzahl an Metallplatten, welche die Elektroden eines Stapelkondensators bilden, durch dielektrische Schichten getrennt, übereinander angeordnet. In jeder Ebene einer Metallplatte ist eine von der jeweiligen Platte isolierte Metalleitung angeordnet. Die Metalleitungen sind jeweils von beiden Seiten mit Via-Verbindungen kontaktiert, wodurch zum einen alle ungeradzahlig und zum anderen alle geradzahlig in dem Stapel positionierten Platten elektrisch miteinander verbunden werden. Indem die geradzahlig positionierten Platten an eine erste Anschlussleitung und die ungeradzahlig positionierten Platten an eine zweite Anschlussleitung angelegt werden, weisen benachbarte Platten unterschiedliches Potenzial auf und bilden jeweils paarweise Elektroden eines Plattenkondensators. Die Kapazitätsoberfläche wird somit durch die Plattenoberflächen gebildet. Eine alternative Ausführung der Elektroden ist dadurch gegeben, dass sie als streifenförmige Leitungen, die in einer waagrechten Ebene parallel zueinander angeordnet sind, ausgebildet sind. Alle ungeradzahlig positionierten Streifen und alle geradzahlig positionierte Streifen sind an einem Ende mit einer elektrischen ebenfalls streifenförmigen Leitung verbunden, wodurch zwei lamellenartige Strukturen gebildet werden, die in der waagrechten Ebenen ineinander verzahnt angeordnet sind. Diese Struktur kann auch in mehreren vertikal zueinander angeordneten Ebenen ausgebildet werden. Nachteilig bei dieser Kapazitätsstruktur sind die relativ geringen Kapazitätswerte pro Fläche sowie relativ hohe Serienwiderstände und Serieninduktivitäten der Struktur.

Eine ähnliche Ausbildung einer Kapazitätsstruktur ist aus der Patentschrift US 5,208,725 bekannt. Auf einem Halbleitersubstrat wird eine Mehrzahl erster streifenförmig ausgebildeter Leitungen parallel zueinander angeordnet. Durch eine dielektrische Schicht getrennt, wird deckungsgleich auf diese ersten Leitungen eine Mehrzahl an zweiten Leitungen angeordnet. Indem vertikal und lateral benachbarte Leitungen auf verschiedenem Potenzial liegen, werden sowohl Kapazitäten zwischen übereinander liegenden Leitungen als auch Kapazitäten zwischen benachbarten Leitungen in einer Ebene erzeugt. Durch die streifenförmige Anordnung werden auch bei dieser Struktur nur relativ geringe Kapazitätswerte pro Fläche erreicht und relativ hohe Serienwiderstände und Serieninduktivitäten erzeugt.

Eine weitere Kapazitätsstruktur ist in Aparicio, R. und Hajimiri, A.: Capacitiy Limits and Matching Properties of Lateral Flux Integrated Capacitors; IEEE Custom Integrated Circuits Conference, San Diego May 6 - 9, 2001, bekannt. Senkrecht angeordnete Stabstrukturen werden symmetrisch zueinander angeordnet. Jeder der Stäbe wird aus Metallbereichen und Via-Bereichen, die abwechselnd aufeinander angeordnet sind aufgebaut. Die Metallflecken eines Stabes sind auf ein gemeinsames Potenzial gelegt. Metallflecken benachbarter Stäbe weisen unterschiedliches Potenzial auf. Die Via-Bereiche kontaktieren jeweils zwei benachbarte Metallbereiche eines Stabes. Ein Nachteil dieser Struktur sind die nur relativ geringen Kapazitätswerte pro Fläche.

Weiterhin ist bei den bekannten Kapazitätsstrukturen nachteilig, dass sie die von ihnen auf dem Chip beanspruchte Fläche nur sehr ineffizient ausnutzen und gemessen an der benötigten Fläche einen relativ geringen Kapazitätswert zur Nutzkapazität liefern und damit einen relativ hohen parasitären Kapazitätsanteil aufweisen.

Die Druckschrift US 6,297,524 B1 beschreibt eine Kapazitätsstruktur, welche eine erste und mindestens eine zweite Metallisierungsebene aufweist, die aus elektrisch leitenden konzentrischen ringförmigen Leitungen aufgebaut sind. Die konzentrischen ringförmigen Leitungen sind dabei in vertikaler Richtung jeweils miteinander verbunden und solchermaßen übereinander gestapelt. Zwischen benachbarten ringförmigen Ebenen innerhalb einer Metallisierungsebene werden somit Kapazitäten ausgebildet, wobei zwischen den Leitungen ein dielektrisches Material angeordnet ist.

Die Druckschrift WO 01/91144 A1 beschreibt eine gattungsgemäße Kapazitätsstruktur, welche im Wesentlichen eine metallische Säule mit einer Anzahl von alternierend übereinander angeordneten metallischen Segmenten und metallischen Via-Segmenten aufweist und eine Elektrode des Kondensators bildet. Die andere Elektrode des Kondensators wird durch eine metallische Wand gebildet, welche die metallische Säule umgibt und ebenfalls aus einer Anzahl von alternierend übereinander gestapelten metallischen Strukturen und metallischen Via-Strukturen aufweist. Es wird ebenfalls beschrieben, dass die Anordnung in lateraler Richtung in mehrfacher Weise ausgebildet werden kann, indem eine Mehrzahl von metallischen Säulen in einer entsprechenden Mehrzahl von Ausnehmungen einer Struktur von mehreren übereinander gestapelten Metallisierungsebenen angeordnet wird.

Die Druckschrift DE 100 19 839 A1 beschreibt einen Mehrschicht-Kondensator, welcher erste innere Elektroden und zweite innere Elektroden aufweist, die einander gegenüberliegend angeordnet sind. Die ersten inneren Elektroden sind über einen ersten Durchführungsleiter mit einer ersten äußeren Anschlusselektrode elektrisch verbunden, wobei die zweiten inneren Elektroden über einen zweiten Durchführungsleiter mit einer zweiten äußeren Anschlusselektrode elektrisch verbunden sind.

Es ist daher Aufgabe der vorliegenden Erfindung, ein Halbleiterbauelement mit einer integrierten Kapazitätsstruktur zu schaffen, welches relativ einfach erzeugt werden kann und bei dem das Verhältnis von Nutzkapazität zu parasitärer Kapazität verbessert werden kann sowie die Serienwiderstände und die Serieninduktivitäten verringert werden können.

Diese Aufgabe wird durch ein Halbleiterbauelement, welches die kennzeichnenden Merkmale des Patentanspruchs 1 aufweist, gelöst.

Ein Halbleiterbauelement weist ein Halbleitersubstrat auf, auf dem ein Schichtensystem aus einer oder mehreren Isolationsschichten angeordnet ist. In dieser Isolationsschicht oder in diesem Isolationsschichten-System ist eine Kapazitätsstruktur ausgebildet. Die Kapazitätsstruktur weist mindestens zwei in vertikaler Richtung zueinander beabstandete Metallisierungsebenen auf, wobei die Metallisierungsebenen im wesentlichen parallel zum Halbleitersubstrat angeordnet und jeweils mit einer Anschlussleitung elektrisch verbunden sind. Ein wesentlicher Gedanke der Erfindung liegt darin, dass eine der Metallisierungsebenen gitterförmig ausgebildet ist und die erste Metallisierungsebene mit zumindest einer elektrisch leitenden, inhomogenen Struktur elektrisch verbunden ist, wobei sich die elektrisch leitende, inhomogene Struktur teilweise zwischen den Metallisierungsebenen und teilweise in einer Aussparung der gitterförmigen Metallisierungsebene erstreckt.

Das erfindungsgemäße Halbleiterbauelement, insbesondere die Kapazitätsstruktur, kann relativ einfach - wenige Maskenschritte - ausgebildet werden und des Weiteren das Verhältnis von Nutzkapazität der Kapazitätsstruktur zur parasitären Kapazität sowie die Kapazitätswerte pro Flächeneinheit verbessert werden. Ein weiterer Vorteil ist dadurch gegeben, dass durch die Gestaltung der Kapazitätsstruktur der horizontale Flächenbedarf der gesamten Kapazitätsstruktur und des gesamten Halbleiterbauelements nahezu nicht vergrößert wird und dadurch auch das Verhältnis von Nutzkapazität zu benötigter Chipfläche wesentlich verbessert wird.

Erfindungsgemäß ist vorgesehen, die inhomogene Struktur stabförmig bzw. säulenförmig auszubilden. Ebenfalls erfindungsgemäß ist die inhomogene Struktur im wesentlichen senkrecht zu den Metallisierungsebenen angeordnet, wobei die inhomogene Struktur zumindest einen metallischen Bereich und einen elektrisch leitenden Verbindungsbereich aufweist, welcher zwischen dem metallischen Bereich und der ersten Metallisierungsebene angeordnet ist. Ebenfalls erfindungsgemäß ist vorgesehen, den Verbindungsbereich als Via-Struktur auszubilden.

Dadurch kann die Oberfläche der Kapazitätsstruktur in vertikaler Richtung möglichst groß gestaltet werden und dadurch ein möglichst großer Beitrag zur Nutzkapazität ohne Vergrößerung des horizontalen Flächenbedarfs der Kapazitätsstruktur erzielt werden.

Die Erfindung kennzeichnet sich dadurch, dass die inhomogene Struktur derart in einer der Aussparungen der gitterförmigen Metallisierungsebene angeordnet ist, dass die gitterförmige Metallisierungsebene und der metallische Bereich der inhomogenen Struktur jeweils in einer horizontalen Ebene angeordnet sind.

Es ist des Weiteren erfindungsgemäß vorgesehen, dass eine zweite gitterförmige Metallisierungsebene beabstandet und deckungsgleich zur ersten gitterförmigen Metallisierungsebene angeordnet ist, wobei die beiden gitterförmigen Metallisierungsebenen durch elektrische Verbindungen miteinander verbunden sind. Die Aussparungen der zweiten gitterförmigen Metallisierungsebene können gleich groß, größer oder kleiner als die Aussparungen in der ersten gitterförmigen Metallisierungsebene sein. Dabei weist die inhomogene Struktur zumindest einen zweiten metallischen Bereich und einen zweiten Verbindungsbereich auf. Die metallischen Bereiche und die Verbindungsbereiche sind in vertikaler Richtung in alternierender Reihenfolge angeordnet, wobei die metallischen Bereiche im Vergleich zueinander mit gleichen oder unterschiedlichen Ausmassen ausgebildet sein können. Insbesondere ist es vorteilhaft die Ausmasse der metallischen Bereiche derart zu gestalten, dass in Abhängigkeit von den Ausmassen der Aussparungen der gitterförmigen Metallisierungsebenen in denen die metallischen Bereiche angeordnet sind, möglichst große Kapazitätsanteile die zur Nutzkapazität der gesamten Kapazitätsstruktur beitragen, auftreten. Es kann auch vorgesehen sein, dass die Verbindungsebene zwischen den beiden gitterförmigen Metallisierungsebenen im wesentlichen entsprechend dieser gitterförmigen Metallisierungsebenen strukturierbar ist. Die Aussparungen in der Verbindungsebene können in ihren Ausmassen gleich groß, größer oder kleiner als die

Aussparungen in den gitterförmigen Metallisierungsebenen ausgebildet sein. Die in der inhomogenen Struktur zwischen den metallischen Bereichen ausgebildeten Verbindungsbereiche können in ihren Ausmassen gleich groß, größer oder kleiner als die Ausmasse der metallischen Bereiche der inhomogenen Struktur sein.

Erfindungsgemäß ist eine weitere gitterförmige Metallisierungsebene in der Kapazitätsstruktur parallel zu den anderen Metallisierungsebenen angeordnet. Diese weitere gitterförmige Metallisierungsebene ist auf derjenigen Seite der ersten Metallisierungsebene angeordnet, die der ersten gitterförmigen Metallisierungsebenen abgewandt ist, so dass gitterförmige Metallisierungsebenen auf verschiedenen Seiten der ersten Metallisierungsebene angeordnet sind. In vertikaler Richtung betrachtet ergibt sich dadurch eine Struktur aus gitterförmigen Metallisierungsebenen zwischen denen die erste Metallisierungsebene angeordnet ist. Erfindungsgemäß ist vorgesehen, zumindest eine zweite inhomogene, elektrisch leitende Struktur auf der Seite der ersten Metallisierungsebene anzuordnen, die sich in Richtung der weiteren gitterförmigen Metallisierungsebene erstreckt und in eine der Aussparungen dieser gitterförmigen Metallisierungsebene zumindest teilweise hineinragt, wobei die Aussparungen der weiteren gitterförmigen Metallisierungsebene im Vergleich zu dem Aussparungen der anderen gitterförmigen Metallisierungsebenen größer sind.

Dadurch kann die Kapazitätsoberfläche erhöht werden und der Anteil der Nutzkapazität weiter vergrößert werden.

Weitere vorteilhafte Ausgestaltungen sind in den Unteransprüchen angegeben.

Anhand der folgenden schematischen Zeichnungen wird ein Ausführungsbeispiel der Erfindung näher erläutert. Es zeigen:
- Fig. 1: eine perspektivische Darstellung eines nicht zur Erfindung gehörigen Ausführungsbeispiels eines Halbleiterbauelements;
- Fig. 2: eine erste Schnittdarstellung des Ausführungsbeispiels gemäß Fig. 1;
- Fig. 3: eine zweite Schnittdarstellung des Ausführungsbeispiels gemäß Fig. 1;
- Fig. 4: eine Ansicht von unten des Ausführungsbeispiels gemäß Fig. 1;
- Fig. 5: eine Ansicht von unten eines nicht zur Erfindung gehörigen Ausführungsbeispiels eines Halbleiterbauelements;
- Fig. 6: eine erste Schnittdarstellung des Ausführungsbeispiels gemäß Fig. 5;
- Fig. 7: eine zweite Schnittdarstellung des Ausführungsbeispiels gemäß Fig. 5;
- Fig. 8: eine dritte Schnittdarstellung des Ausführungsbeispiels gemäß Fig. 5;
- Fig. 9: eine vierte Schnittdarstellung des Ausführungsbeispiels gemäß Fig. 5;
- Fig. 10: eine Ansicht von unten eines Ausführungsbeispiels des erfindungsgemäßen Halbleiterbauelements;
- Fig. 11: eine erste Schnittdarstellung des Ausführungsbeispiels gemäß Fig. 10;
- Fig. 12: eine zweite Schnittdarstellung des Ausführungsbeispiels gemäß Fig. 10; und
- Fig. 13: eine dritte Schnittdarstellung des Ausführungsbeispiels gemäß Fig. 10.
In den Figuren sind gleiche oder funktionsgleiche Elemente mit gleichen Bezugszeichen bezeichnet.

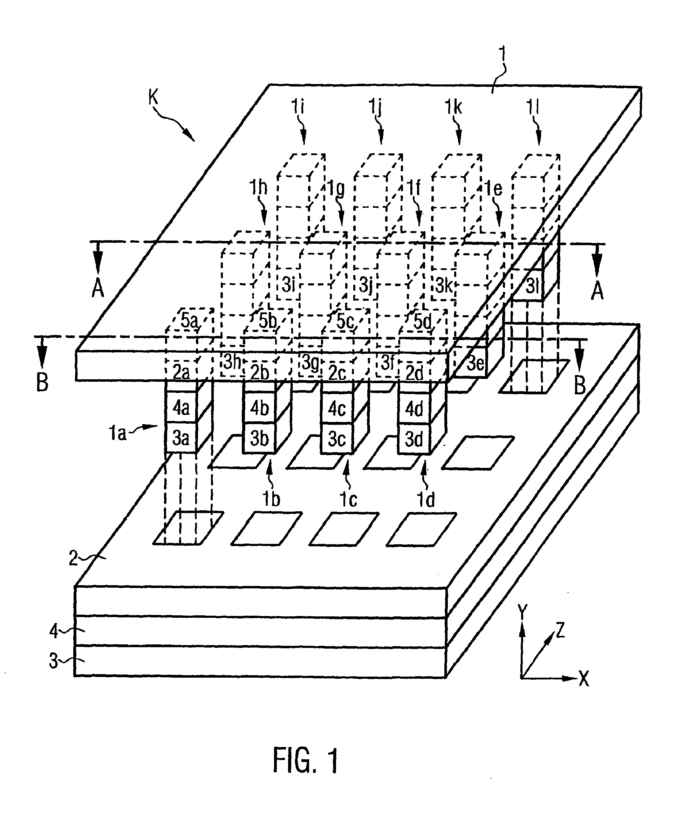

In einem nicht zur Erfindung gehörigen Ausführungsbeispiel weist ein erfindungsgemäßes Halbleiterbauelement (Fig. 1) ein nicht dargestelltes Halbleitersubstrat auf, auf dem eine nicht dargestellte Isolationsschicht aufgebracht ist. Die Isolationsschicht kann auch aus mehreren Schichten bestehen. In dieser Isolationsschicht ist eine Kapazitätsstruktur K integriert. Die Kapazitätsstruktur K weist eine erste Metallisierungsebene 1 auf, die im Ausführungsbeispiel als homogene Platte 1 ausgeführt ist.

An der homogenen Platte 1 sind mehrere säulenförmig ausgebildete, elektrisch leitende, inhomogene Strukturen 1a bis 11 senkrecht zur Platte 1 angeordnet und in Richtung zu einer ersten gitterförmigen Metallisierungsebene 2 orientiert, welche die zweite Metallisierungsebene der Kapazitätsstruktur darstellt. Die erste gitterförmige Metallisierungsebene 2 ist parallel zur homogenen Platte 1 angeordnet. Im Ausführungsbeispiel ist eine zweite gitterförmige Metallisierungsebene 3 parallel und beabstandet zu der ersten gitterförmigen Metallisierungsebene 2 angeordnet, wobei die gitterförmigen Metallisierungsebenen 2 und 3 durch eine elektrisch leitende Verbindungsebene 4 miteinander verbunden sind. Die zweite gitterförmige Metallisierungsebene 3 und die Verbindungsebene 4 weisen entsprechend der ersten gitterförmigen Metallisierungsebene 2 ausgebildete Aussparungen auf und die Ebenen 2, 3 und 4 sind derart zueinander angeordnet, dass die Aussparungen deckungsgleich übereinander liegen.

Die säulenförmigen, elektrisch leitenden Strukturen 1a bis 1l weisen jeweils metallische Bereiche 2a und 3a bis 2l und 3l auf. Zwischen diesen metallischen Bereichen ist jeweils eine Via-Struktur 4a bis 4l und 2a bis 2l ausgebildet. Die metallischen Bereiche 2a bis 2l werden in derjenigen Metallisierungslage ausgebildet, in der die gitterförmige Metallisierungsebene 2 ausgebildet ist. Ebenso werden die Via-Strukturen 4a bis 41 in derjenigen Verbindungslage ausgebildet, in der die Verbindungsebene 4 ausgebildet ist und die metallischen Bereiche 3a bis 31 in der Metallisierungslage ausgebildet, in der die gitterförmige Metallisierungsebene 3 ausgebildet ist. Auf den metallischen Bereichen 2a bis 21 sind die Via-Strukturen 5a bis 51 angeordnet, die aus einer nicht dargestellten Verbindungslage erzeugt werden, wobei diese Verbindungslage bis auf die bestehenden Vias 5a bis 51 wieder entfernt wird.

Die Säulen bzw. Stäbe 1a bis 1l sind derart in den Aussparungen der Ebenen 2, 3 und 4 angeordnet, dass die metallischen Bereiche 2a bis 2l mit der ersten gitterförmigen Metallisierungsebene 2, die Vias 4a bis 4l mit der Verbindungsebene 4 und die metallischen Bereiche 3a bis 3l mit der gitterförmigen Metallisierungsebene 3 jeweils in einer horizontalen Ebene angeordnet sind. Die Aussparungen der Ebenen 2, 3 und 4 sind größer ausgebildet als die Stäbe 1a bis 1l, so dass die einzelnen Bereiche 2a, ..., 5a bis 2l, ..., 5l eines jeden Stabes 1a bis 11 beabstandet zu denjenigen Randbereichen der jeweiligen Aussparung sind, in der ein einzelner Stab angeordnet ist.

Die Bereiche zwischen den Stäben 1a bis 1l und den Randbereichen der Aussparungen sind mit einem dielektrischen Material gefüllt. Ebenso ist zwischen der metallischen homogenen Platte 1 und der gitterförmigen Metallisierungsebene 2 eine nicht dargestellte dielektrische Schicht bzw. eine Isolationsschicht ausgebildet. Die Platte 1 und die Stäbe 1a bis 1l sind mit einer ersten Anschlussleitung und die gitterförmigen Ebenen 2, 3 und 4 sind mit einer zweiten Anschlussleitung zur Erzeugung von Kondensatorelektroden elektrisch verbunden.

Die in Fig.1 dargestellte Kapazitätsstruktur K kann auch um 180° gedreht ausgebildet sein, so dass die Platte 1 dem Halbleitersubstrat am nächsten liegt und sich die Säulen 1a bis 1l in positiver y-Richtung nach oben hin erstrecken. Es kann auch vorgesehen sein, die gitterförmige Metallisierungsebene 3 und die Verbindungsebene 4 sowie die entsprechenden Bereiche 3a bis 3l und 4a bis 4l der Stäbe 1a bis 1l wegzulassen. Die Kapazitätsstruktur K kann aber auch mit weiteren gitterförmigen Metallisierungsebenen und Verbindungsebenen ausgebildet sein, die in alternierender Reihenfolge an die gitterförmige Metallisierungsebene 3 angrenzend angeordnet sind.

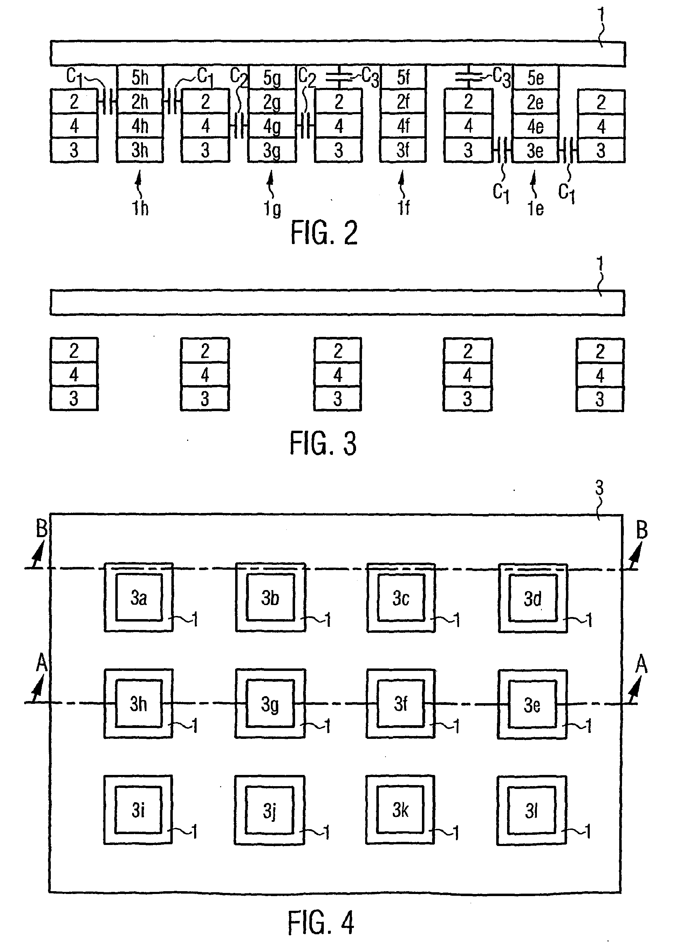

In Fig. 2 ist eine Schnittdarstellung entlang der Schnittlinie AA gemäß Fig. 1 gezeigt. Die Stäbe 1e bis 1h sind zu den Randbereichen der Aussparungen der Ebenen 2, 3 und 4 beabstandet, so dass zwischen den gegenüberliegenden Oberflächenbereichen Kapazitätsanteile die zur Nutzkapazität beitragen, gebildet werden. Erste Kapazitätsanteile C₁ werden jeweils zwischen der gitterförmigen Metallisierungsebene 2 und den metallischen Bereichen 2e bis 2h der Stäbe 1e bis 1h und der gitterförmigen Metallisierungsebene 3 und den metallischen Bereichen 3e bis 3h der Stäbe 1e bis 1h gebildet. Beispielhaft sind diese Kapazitätsanteile C₁ zwischen der gitterförmigen Metallisierungsebene 2 und dem metallischen Bereich 2h des Stabes 1h und zwischen der gitterförmigen Metallisierungsebene 3 und dem metallischen Bereich 3e des Stabes 1e eingezeichnet. Zweite Kapazitätsanteile C₂ die zur Nutzkapazität der Kapazitätsstruktur K beitragen, werden jeweils zwischen der Verbindungsebene 4 und den Via-Bereichen 4e bis 4h der Stäbe 1e bis 1h gebildet. Beispielhaft sind diese Kapazitätsanteile C₂ zwischen der Verbindungsebene 4 und dem Via-Bereich 4g des Stabes 1g eingezeichnet. Des Weiteren werden Kapazitätsanteile C₃ zwischen der Metallisierungsebene 1 und der gitterförmigen Metallisierungsebene 2 erzeugt, die ebenfalls zur Nutzkapazität beitragen (beispielhaft sind in Fig. 2 zwei Kapazitätsanteile C₃ eingezeichnet).

In Fig. 3 ist eine Schnittdarstellung der Fig. 1 entlang der Schnittlinie BB dargestellt. Diese Schnittlinie ist im Bereich des Dielektrikums zwischen den Stäben 1a bis 1d und den Randbereichen der Aussparungen, in denen diese Stäbe 1a bis 1d angeordnet sind, gezogen.

Eine Darstellung mit einer Ansicht von unten der in Fig. 1 ausgebildeten Kapazitätsstruktur K, ist in Fig. 4 gezeigt. In den Aussparungen der gitterförmigen Metallisierungsebene 3 sind die metallischen Bereiche 3a bis 31 der Stäbe 1a bis 11 zentrisch angeordnet. Zur Verdeutlichung des Schnittlinienverlaufs der Schnittlinien AA und BB sind diese an den entsprechenden Stellen eingezeichnet.

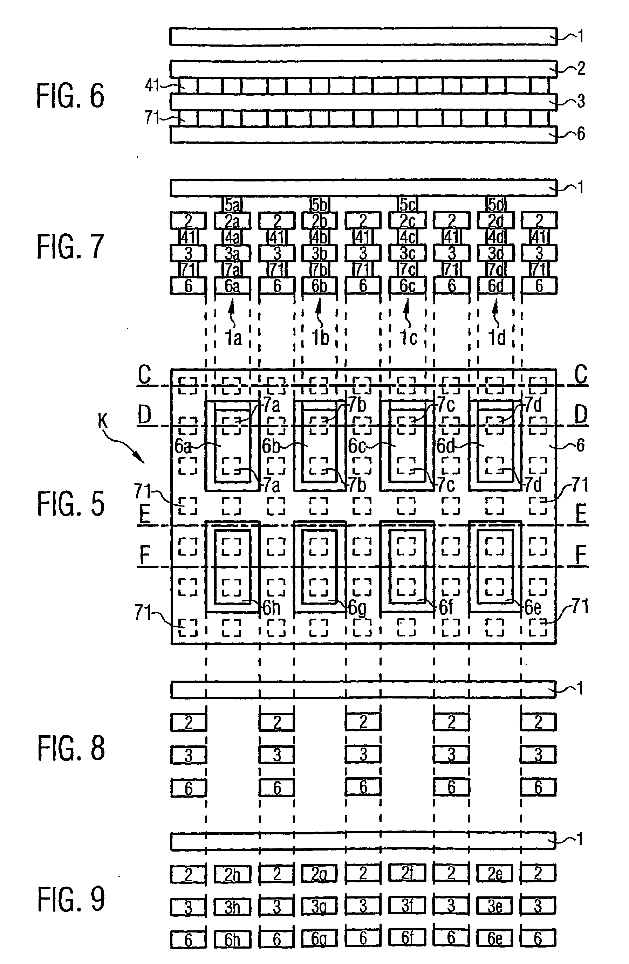

Ein nicht zur Erfindung gehöriges Ausführungsbeispiel ist in den Figuren 5 bis 9 gezeigt. Fig. 5 zeigt eine Ansicht von unten auf die Kapazitätsstruktur K. Eine gitterförmige Metallisierungsebene 6 weist rechteckige Aussparungen auf, in denen jeweils ein metallischer Bereich 6a bis 6h eines Stabes 1a bis 1h zentrisch angeordnet ist. Die Kapazitätsstruktur K dieses Ausführungsbeispiels weist drei gitterförmige Metallisierungsebene 2, 3 und 6 (in Fig. 5 nicht dargestellt) auf. Die elektrische Verbindung zwischen diesen gitterförmigen Metallisierungsebenen 2, 3 und 6 ist in diesem Ausführungsbeispiel jeweils durch säulenartige Via-Strukturen realisiert, die in der Fig. 5 durch die gestrichelten Bereiche 71 beispielhaft verdeutlicht sind.

In Fig. 6 ist eine Schnittdarstellung des Ausführungsbeispiels entlang der Schnittlinie CC gezeigt. Die gitterförmige Metallisierungsebene 2 ist mit der gitterförmigen Metallisierungsebene 3 über säulenartige Vias 41 elektrisch verbunden. Die gitterförmige Metallisierungsebene 6 ist mit der gitterförmigen

Metallisierungsebene 3 über säulenartige Vias 71 elektrisch verbunden. Die erste Metallisierungsebene 1 ist mit einer ersten Anschlussleitung und die gitterförmigen Metallisierungsebenen 2, 3 und 6 mit einer zweiten Anschlussleitung elektrisch verbunden.

In Fig. 7 ist eine Schnittdarstellung des Ausführungsbeispiels der Kapazitätsstruktur K entlang der Schnittlinie DD gemäß Fig. 5 gezeigt. Die Aussparungen in den drei gitterförmigen Metallisierungsebenen 2, 3 und 6 sind in diesem Ausführungsbeispiel mit verschiedenen Ausmassen ausgebildet. So weist die gitterförmige Metallisierungsebene 2 die größten und die gitterförmige Metallisierungsebene 6 die kleinsten Aussparungen auf. Wie in der Fig. 7 dargestellt sind die metallischen Bereiche 2a, 3a, 6a bis 2d, 3d, 6d der Stäbe 1a bis 1d mit verschiedenen Ausmassen ausgebildet. Die metallischen Bereiche 6a bis 6d weisen die größten und die metallischen Bereiche 2a bis 2d die kleinsten Ausmasse auf. Dadurch sind die Abstände zwischen den metallischen Bereichen 2a bis 2d, 3a bis 3d und 6a bis 6d und den Randbereichen der Aussparungen der gitterförmigen Metallisierungsebenen 2, 3 und 6 in jeder der Ebenen unterschiedlich. Mittels der Vias 5a bis 5d sind die Stäbe 1a bis 1d mit der Metallisierungsebene 1 elektrisch verbunden. Im Ausführungsbeispiel sind die Vias 41 und die Vias 71 mit gleichen Ausmassen zueinander und kleiner als die metallischen Bereiche der gitterförmigen Metallisierungsebenen 2, 3 und 6 dargestellt. Es kann auch vorgesehene sein, diese Vias 41 und 71 mit unterschiedlichen Ausmassen auszubilden und beispielsweise gleich groß oder größer als die metallischen Bereiche der gitterförmigen Metallisierungsebenen 2, 3 und 6 auszubilden.

Eine weitere Schnittdarstellung entlang der Schnittlinie EE gemäß Fig. 5 ist in der Fig. 8 dargestellt. Dieser Schnitt ist im Bereich zwischen dem Randbereich der Aussparung der gitterförmigen Metallisierungsebene 6 und den metallischen Bereichen 6e bis 6h gezogen.

Eine Schnittdarstellung entlang der Schnittlinie FF in Fig. 5 ist in der Fig. 9 gezeigt. Sowohl die gitterförmigen Metallisierungsebenen 2, 3 und 6 als auch die metallischen Bereiche 2e, 3e, 6e bis 2h, 3h, 6h der Stäbe 1e bis 1h weisen hier keine elektrische Verbindung auf.

Erste Kapazitätsanteile C₁ (nicht dargestellt) welche zur Nutzkapazität der gesamten Kapazitätsstruktur K des zweiten Ausführungsbeispiels (Fig. 5 bis 9) beitragen, bilden sich zwischen den sich gegenüberstehenden Oberflächenbereichen der gitterförmigen Metallisierungsebenen 2, 3 und 6 und den entsprechenden metallischen Bereichen 2a, 3a, 6a bis 2h, 3h, 6h der Stäbe 1a bis 1h aus. Zweite, zur Nutzkapazität beitragende Kapazitätsanteile C₂ werden zwischen den einander zugewandten Oberflächenbereichen der Via-Strukturen 41 und 71 und den entsprechenden Verbindungsbereichen 4a und 7a bis 4h bis 7h der Stäbe 1a bis 1h erzeugt. Ebenso wie im Ausführungsbeispiel gemäß Fig. 2 werden dritte Kapazitätsanteile C₃ zwischen der ersten Metallisierungsebene 1 und der gitterförmigen Metallisierungsebene 2 erzeugt.

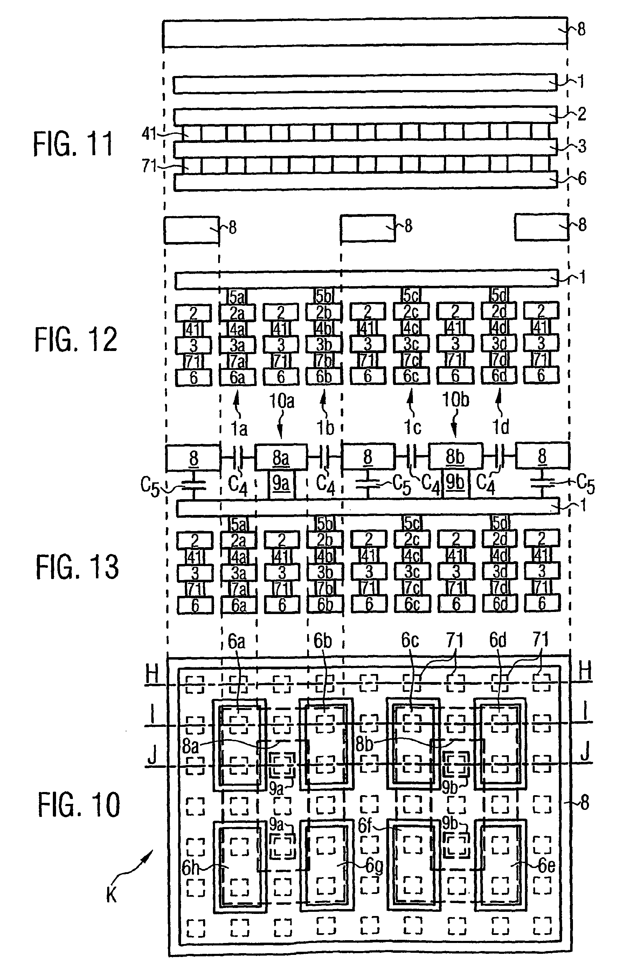

Ein erfindungsgemäßes Ausführungsbeispiel einer Kapazitätsstruktur K ist in den Figuren 10 bis 13 dargestellt. Entsprechend der Fig. 5 weist die in Fig. 10 (Ansicht von unten) dargestellte Kapazitätsstruktur metallische Bereiche 6a bis 6h auf, die Teilbereiche der Stäben 1a bis 1h sind. Des Weiteren weist die Kapazitätsstruktur K eine gitterförmige Metallisierungsebene 8 auf, in deren Aussparungen metallische Bereiche 8a und 8b (gestrichelt dargestellt) zentrisch angeordnet sind. Diese rechteckig ausgebildeten, metallischen Bereiche 8a und 8b weisen im Ausführungsbeispiel größere Ausmasse auf, als die Aussparungen in den gitterförmigen Metallisierungsebenen 2, 3 und 6. Jeder dieser metallischen Bereiche 8a und 8b ist jeweils durch zwei Vias 9a bzw. zwei

Vias 9b mit der ersten Metallisierungsebene 1 elektrisch verbunden.

In Fig. 11 ist eine Schnittdarstellung der Kapazitätsstruktur gemäß Fig. 10 entlang der Schnittlinie HH gezeigt. Die gitterförmige Metallisierungsebene 8 ist oberhalb der ersten Metallisierungsebene 1 angeordnet, so dass die gitterförmigen Metallisierungsebenen 2, 3 und 6 auf einer Seite der ersten Metallisierungsebene 1 und die gitterförmige Metallisierungsebene 8 auf der anderen Seite der ersten Metallisierungsebene 1 angeordnet sind. Im Ausführungsbeispiel sind die gitterförmigen Metallisierungsebenen 2, 3 und 6 in feinstrukturierbaren Metallisierungslagen und die gitterförmige Metallisierungsebene 8 in einer grobstrukturierbaren Metallisierungslage ausgebildet. In diesem Ausführungsbeispiel sind die gitterförmigen Metallisierungsebenen 2, 3, 6 und 8 mit der zweiten Anschlussleitung elektrisch verbunden.

Gemäß der Schnittdarstellung in Fig. 12, welche einen Schnitt entlang der Schnittlinie II der Kapazitätsstruktur K in Fig. 10 zeigt, sind die relativ größeren Aussparungen der gitterförmigen Metallisierungsebene 8 im Vergleich zu den Aussparungen der anderen gitterförmigen Metallisierungsebenen 2, 3 und 6 zu erkennen.

Eine weitere Schnittdarstellung ist in Fig. 13 gezeigt. Diese Figur zeigt einen Schnitt entlang der Schnittlinie JJ gemäß Fig. 10. Der metallische Bereich 8a und die beiden Via-Strukuren 9a (in der Schnittdarstellung nur ein Via 9a zu erkennen) bilden eine inhomogene Struktur 10a, die mit der ersten Metallisierungsebene 1 verbunden ist. Des Weiteren bildet der metallische Bereich 8b und die beiden Vias 9b (in der Schnittdarstellung ein Via 9b zu erkennen) eine inhomogene Struktur 10b, welche ebenfalls mit der ersten Metallisierungsebene 1 elektrisch verbunden ist.

Die Nutzkapazität der Kapazitätsstruktur K gemäß den Fig. 10 bis 13 enthält Kapazitätsanteile C₁, C₂ und C₃, die entsprechend denen im Ausführungsbeispiel der Figuren 5 bis 9 erzeugt werden. Weitere zur Nutzkapazität beitragende Kapazitätsanteile C₄ (Fig. 13) werden zwischen einander zugewandten Oberflächenbereichen zwischen den metallischen Bereichen 8a und 8b und den Aussparungen der gitterförmigen Metallisierungsebene 8 erzeugt. Weiter werden zwischen den einander zugewandten Oberflächenbereichen der gitterförmigen Metallisierungsebene 8 und der ersten Metallisierungsebene 1 Kapazitätsanteile C₅ (Fig. 13) erzeugt, die zur Nutzkapazität beitragen.

Die Anzahl der Stäbe sowie die Aussparungen in den jeweiligen gitterförmigen Ebenen ist nicht auf die in den Ausführungsbeispielen gezeigten Anzahl beschränkt, sondern kann in horizontaler Richtung in vielfältiger Weise und in einer Mehrzahl an zusätzlichen Stäben und Aussparungen erweitert werden.

Es kann auch vorgesehen sein, mehrere gitterförmige Metallisierungsebenen, die entsprechend der gitterförmigen Metallisierungsebene 8 ausgebildet sind, aufeinander anzuordnen. Es ist auch möglich, die durch die Stäbe 1a bis 1h, die gitterförmigen Metallisierungsebenen 2, 3 und 6 sowie die Verbindungsbereiche 41 und 71 erzeugte Teilstruktur der Kapazitätsstruktur K in symmetrischer Weise an der zu dieser Teilstruktur abgewandten Seite der ersten Metallisierungsebene 1 anzuordnen. Eine derartige symmetrische Anordnung ist generell bei allen Ausbildungen der Kapazitätsstruktur K des erfindungsgemäßen Halbleiterbauelements möglich. Es kann auch vorgesehen sein, dass die erste Metallisierungsebene 1 ebenfalls gitterförmig ausgebildet ist bzw. symmetrisch oder unsymmetrisch ausgebildete Aussparungen aufweist.

Die elektrisch leitenden Verbindungslagen zwischen den Metallisierungslagen können in modernen Integrationsprozessen prinzipiell als eigene, zu den Metallisierungslagen entsprechend strukturierbare Lage, aufgefasst werden. Dadurch lassen sich vertikal zum Halbleitersubstrat orientierte, elektrisch leitende Strukturen aufbauen, die vertikale Gesamthöhen bis zu mehreren Mikrometern erreichen können. Die Verbindungsebenen und die Metallisierungsebenen können abhängig von der verwendeten Technologie gleich strukturierbar sein. Dadurch können die inhomogenen Strukturen, die mit der ersten Metallisierungsebene 1 verbunden sind, Verbindungsbereiche zwischen den metallischen Bereichen aufweisen, die im wesentlichen diesen metallischen Bereichen entsprechen. Die inhomogene Struktur wird in diesem Fall durch im wesentlichen gleiche, aufeinander angeordnete metallische Bereiche gebildet.

Durch die Kapazitätsstruktur K des erfindungsgemäßen Halbleiterbauelements können zum einen relativ hohe Nutzkapazitätswerte pro Fläche erreicht und zum anderen die parasitären Kapazitäten zu bzw. in den Kondensatorelektroden relativ gering gehalten werden. Des Weiteren können die Serienwiderstände und die Serieninduktivitäten in der Kapazitätsstruktur K relativ gering gehalten werden. Das Halbleiterbauelement mit einer derartig ausgebildeten Kapazitätsstruktur eignet sich deshalb insbesondere für den Einsatz im GHz-Frequenzbereich.

In dem erfindungsgemäßen Ausführungsbeispielen kann eine Kapazitätsstruktur K hergestellt werden, die mit relativ wenig Aufwand - relativ wenig Maskenschritten - erzeugt werden kann und welche bei nahezu unverändertem horizontalen Flächenbedarf der Kapazitätsstruktur auf der Chipfläche eine relativ große Kapazitätsoberfläche erzeugt, mit welcher das Verhältnis von Nutzkapazität zu parasitärer Kapazität verbessert werden kann.

Die Erfindung ist nicht auf die in dem Ausführungsbeispiel dargestellte Kapazitätsstruktur K beschränkt, sondern kann in vielfältiger Weise ausgebildet sein. Alle gezeigten Ausführungsbeispiele können sinngemäß auf eine Vielzahl an Integrationsprozessen mit einer Mehrzahl von fein- oder grobstrukturierbaren Metallisierungslagen (Verdrahtungsebenen) übertragen werden. Die Anzahl der Metallisierungslagen wie auch deren relative Schichtdicken und vertikalen Abständen zueinander ersetzen die hier gezeigten Ideen nicht, sondern sind lediglich als äquivalente Mittel bzw. Ausführungsalternativen zur Umsetzung der hier dargestellten Konzepte anzusehen.

## Patentansprüche

1. Halbleiterbauelement
- mit einem Halbleitersubstrat und einer auf dem Halbleitersubstrat ausgebildeten Isolationsschicht und
- mit einer Kapazitätsstruktur (K), welche in der Isolationsschicht ausgebildet ist, wobei die Kapazitätsstruktur (K) mindestens zwei in vertikaler Richtung zueinander beabstandete Metallisierungsebenen (1, 2, 3, 6) aufweist, welche sich im wesentlichen parallel zur Substratoberfläche erstrecken und jeweils mit einer von zwei Anschlussleitungen elektrisch verbunden sind, wobei
- eine (2) der Metallisierungsebenen (2, 3, 6) gitterförmig ausgebildet ist und eine Anordnung in sich geschlossener Aussparungen aufweist,
- eine erste Metallisierungsebene (1) mit zumindest einer elektrisch leitenden, inhomogenen Struktur (1a bis 11) elektrisch verbunden ist, wobei sich die elektrisch leitende, inhomogene Struktur (1a bis 1l) teilweise zwischen einander benachbarten Metallisierungsebenen (1, 2, 3, 6) und teilweise in einer Aussparung der ersten gitterförmigen Metallisierungsebene (2) erstreckt, und
- eine zweite gitterförmige Metallisierungsebene (3), welche deckungsgleich und beabstandet zur ersten gitterförmigen Metallisierungsebene (2) angeordnet ist, wobei die zweite gitterförmige Metallisierungsebene (3) eine Anordnung in sich geschlossener Aussparungen aufweist, welche mit den Aussparungen der ersten gitterförmigen Metallisierungsebene (2) fluchten, und die beiden gitterförmigen Metallisierungsebenen (2, 3) durch elektrische Verbindungen (4; 41) verbunden sind,
- die inhomogene Struktur (1a bis 1l) stabförmig ausgebildet und senkrecht zu den Metallisierungsebenen (1, 2, 3, 6) angeordnet ist,
- die inhomogene Struktur (1a bis 1l) einen ersten metallischen Bereich (2a bis 2l), einen zwischen dem ersten metallischen Bereich (2a bis 2l) und der ersten Metallisierungsebene (1) ausgebildeten ersten elektrisch leitenden Verbindungsbereich (5a bis 51), einen zweiten metallischen Bereich (3a bis 31) und einen zwischen dem ersten metallischen Bereich (2a bis 21) und dem zweiten metallischen Bereich ausgebildeten zweiten elektrisch leitenden Verbindungsbereich (4a bis 4l) aufweist, und
- die inhomogene Struktur (1a bis 1l) derart in den Aussparungen der ersten gitterförmigen Metallisierungsebene (2) und der zweiten gitterförmigen Metallisierungsebene (3) angeordnet ist, dass der erste metallische Bereich (2a bis 2l) in der ersten gitterförmigen Metallisierungsebene (2), der zweite metallische Bereich (3a bis 3l) in der zweiten gitterförmigen Metallisierungsebene (3) und der zweite elektrisch leitende Verbindungsbereich (4a bis 4l) in der Ebene der elektrischen Verbindungen (4; 4l) liegt,
**dadurch gekennzeichnet, dass**
- eine weitere gitterförmige Metallisierungsebene (8) auf derjenigen Seite der ersten Metallisierungsebene (1) ausgebildet ist, die der ersten gitterförmigen Metallisierungsebene (2) abgewandt ist, wobei die weitere gitterförmige Metallisierungsebene (8) Aussparungen aufweist,
- zumindest eine zweite elektrisch leitende, inhomogene Struktur (10a, 10b) auf der zur ersten inhomogenen Struktur (1a bis 1l) abgewandten Seite der ersten Metallisierungsebene (1) ausgebildet ist und mit dieser elektrisch verbunden ist und sich zumindest teilweise in die Aussparungen der weiteren gitterförmigen Metallisierungsebene (8) hinein erstreckt, wobei
- die Aussparungen der weiteren gitterförmigen Metallisierungsebene (8) im Vergleich zu den Aussparungen der anderen gitterförmigen Metallisierungsebenen (2, 3) größer sind.

2. Halbleiterbauelement nach Anspruch 1,
**dadurch gekennzeichnet, dass** die Aussparungen in der zweiten Metallisierungsebene (3) gleich groß wie die Aussparungen in der ersten gitterförmigen Metallisierungsebene (2) sind.

3. Halbleiterbauelement nach Anspruch 1 oder 2,
**dadurch gekennzeichnet, dass** der erste metallische Bereich (2a bis 2l) und der zweite metallische Bereich (3a bis 3l) gleiche oder unterschiedliche Ausmaße aufweisen.

## Claims

1. Semiconductor component
- comprising a semiconductor substrate and an insulation layer formed on the semiconductor substrate,
- comprising a capacitance structure (K) formed in the insulation layer, wherein the capacitance structure (K) has at least two metallization planes (1, 2, 3, 6) which are spaced apart in a vertical direction with respect to one another and which extend substantially parallel to the substrate surface and are in each case electrically connected to one of two connecting lines, wherein
- one (2) of the metallization planes (2, 3, 6) is formed in latticed fashion and has an arrangement of self-contained cutouts,
- a first metallization plane (1) is electrically connected to at least one electrically conductive, inhomogeneous structure (1a to 1l) wherein the electrically conductive, inhomogeneous structure (1a to 1l) extends partly between each of the adjacent metallization planes (1, 2, 3, 6) and partly in a cutout of the first latticed metallization plane (2), and
- a second latticed metallization plane (3), which is arranged congruently and in a manner spaced apart with respect to the first latticed metallization plane (2), wherein the second latticed metallization plane (3) has an arrangement of self-contained cutouts which are aligned with the cutouts of the first latticed metallization plane (2), and the two latticed metallization planes (2, 3) are connected by electrical connections (4; 41),
- the inhomogeneous structure (1a to 1l) is embodied in bar-shaped fashion and is arranged perpendicularly to the metallization planes (1, 2, 3, 6),
- the inhomogeneous structure (1a to 1l) has a first metallic region (2a to 21), a first electrically conductive connection region (5a to 5l) formed between the first metallic region (2a to 2l) and the first metallization plane (1), a second metallic region (3a to 3l) and a second electrically conductive connection region (4a to 4l) formed between the first metallic region (2a to 2l) and the second metallic region, and
- the inhomogeneous structure (1a to 1l) is arranged in the cutouts of the first latticed metallization plane (2) and the second latticed metallization plane (3) in such a way that the first metallic region (2a to 2l) lies in the first latticed metallization plane (2), the second metallic region (3a to 3l) lies in the second latticed metallization plane (3) and the second electrically conductive connection region (4a to 41) lies in the plane of the electrical connections (4; 4l),
**characterized in that**
- a further latticed metallization plane (8) is formed on that side of the first metallization plane (1) which faces away from the first latticed metallization plane (2), wherein the further latticed metallization plane (8) has cutouts,
- at least one second electrically conductive, inhomogeneous structure (10a, 10b) is formed on that side of the first metallization plane (1) which faces away with respect to the first inhomogeneous structure (1a to 1l) and is electrically connected to said metallization plane and extends at least partly into the cutouts of the further latticed metallization plane (8), wherein
- the cutouts of the further latticed metallization plane (8) are larger in comparison with the cutouts of the other latticed metallization planes (2, 3).

2. Semiconductor component according to Claim 1,
**characterized in that**
the cutouts in the second metallization plane (3) are of the same size as the cutouts in the first latticed metallization plane (2).

3. Semiconductor component according to Claim 1 or 2,
**characterized in that**
the first metallic region (2a to 21) and the second metallic region (3a to 31) have identical or different dimensions.

## Revendications

1. Composant à semi-conducteur
- comprenant un substrat semi-conducteur et une couche isolante formée sur le substrat semi-conducteur, et
- comprenant une structure (K) de capacité qui est formée dans la couche isolante, la structure (K) de capacité ayant au moins deux plans (1, 2, 3, 6) de métallisation à distance l'un de l'autre dans la direction verticale, qui s'étendent sensiblement parallèlement à la surface du substrat et qui sont reliés électriquement respectivement à l'une de deux lignes de connexion, dans lequel
- l'un (2) des plans (2, 3, 6) de métallisation est constitué sous la forme d'une grille et comporte un agencement d'évidements en soi fermé,
- un premier plan de métallisation est relié électriquement à au moins une structure (1a à 11) conductrice de l'électricité et non homogène, la structure (1a à 11) conductrice de l'électricité et non homogène s'étendant en partie entre des plans (1, 2, 3, 6) de métallisation voisins les uns des autres et en partie dans un évidement du premier plan (2) de métallisation en forme de grille, et
- un deuxième plan (3) de métallisation en forme de grille qui est disposé en coïncidence avec le premier plan (2) de métallisation en forme de grille et à distance de celui-ci, le deuxième plan (3) de métallisation en forme de grille comportant un agencement d'évidements en soi fermé, qui sont alignés avec les évidements du premier plan (2) de métallisation en forme de grille et les deux plans (2, 3) de métallisation en forme de grille sont reliés par des liaisons (4 ; 41) électriques,
- la structure (1a à 11) non homogène est en forme de barreau et est disposée perpendiculairement au plan (1, 2, 3, 6) de métallisation,
- la structure (1a à 11) non homogène comporte une première zone (2a à 21) métallique, une première zone (5a à 51) de liaison, conductrice de l'électricité, formée entre la première zone (2a à 21) de métallisation et le premier plan (1) de métallisation et une deuxième zone (4a à 41) de liaison, conductrice de l'électricité, formée entre le première zone (2a à 21) de métallisation et la deuxième zone de métallisation, et
- la structure (1a à 11) non homogène est disposée dans les évidements du premier plan (2) de métallisation en forme de grille et du deuxième plan (3) de métallisation en forme de grille de manière à ce que la première zone (2a à 21) métallique se trouve dans le premier plan (2) de métallisation en forme de grille, la deuxième zone (3a à 31) métallique dans le deuxième plan (3) de métallisation en forme de grille et la deuxième zone (4a à 41) de liaison, conductrice de l'électricité, dans le plan des liaisons (4 ; 41) électriques,
**caractérisé en ce que**
- un autre plan (8) de métallisation en forme de grille est formé du côté du premier plan (1) de métallisation qui est éloigné du premier plan (2) de métallisation en forme de grille, l'autre plan (8) de métallisation en forme de grille ayant des évidements,
- au moins une deuxième structure (10a, 10b), conductrice de l'électricité et non homogène, est formée du côté du premier plan (1) de métallisation éloigné de la première structure (1a à 1l) non homogène et est reliée électriquement à celui-ci et s'étend au moins en partie dans les évidements de l'autre plan (8) de métallisation en forme de grille, dans lequel
- les évidements de l'autre plan (8) de métallisation en forme de grille sont plus grands que les évidements des autres plans (2, 3) de métallisation en forme de grille.

2. Composant à semi-conducteur suivant la revendication 1, **caractérisé en ce que** les évidements dans le deuxième plan (3) de métallisation ont la même dimension que les évidements dans le premier plan (2) de métallisation en forme de grille.

3. Composant à semi-conducteur suivant la revendication 1 ou 2, **caractérisé en ce que** la première zone (2a à 21) métallique et la deuxième zone (3a à 31) métallique ont des dimensions identiques ou différentes.
